# EUROPEAN PATENT APPLICATION

(11) **EP 4 582 372 A1**
(43) Date of publication of application: **09.07.2025**
(21) Application number: 23860425.0
(22) Date of filing: 30.08.2023
(51) Int. Cl.: C01B 21/072, H01L 23/373

(54) **ALUMINUM NITRIDE POWDER AND RESIN COMPOSITION**

(30) Priority: 31.08.2022 JP 2022138688
(71) Applicant: TOKUYAMA CORPORATION, Yamaguchi 745-8648 (JP)
(72) Inventor: SAKAMOTO, Atsushi, Shunan-shi, Yamaguchi 745-8648 (JP); FUJII, Saiko, Shunan-shi, Yamaguchi 745-8648 (JP); MASADA, Isao, Shunan-shi, Yamaguchi 745-8648 (JP)
(74) Representative: Kraus & Lederer PartGmbB
(86) International application number: PCT/JP2023/031578
(87) International publication number: WO 2024/048663

(57) **Abstract**

Provided is an aluminum nitride powder, containing (i) 60 vol% or more of the proportion of the particles in the range of 5 to 150 µm in all the particles in the volume-based particle size distribution measured by particle size analysis; and having (ii) peaks in the particle size range of 5 to 50 µm (M range) and the particle size range of more than 50 µm and 150 µm or less (L range) in the frequency distribution curve obtained from the particle size distribution measurement, and having 0.2 to 1.0 of the ratio (Mᵢₙₜ/Lᵢₙₜ) of the proportion (Mᵢₙₜ) of particles in the M range to the proportion (Lᵢₙₜ) of particles in the L range, wherein, in the scanning electron microscope image taken at 500x magnification, 50% or more of the particles with a particle size belonging to 5 to 50 µm are polyhedral particles having at least two flat surfaces.

## Description

### TECHNICAL FIELD

The present invention relates to an aluminum nitride powder and a resin composition containing the aluminum nitride powder.

### BACKGROUND ART

With the advancement of electronic apparatus' performance, semiconductor elements are increasing in density and mounting. Accordingly, it is becoming important to more efficiently dissipate heat generated by electronic components that constitute the electronic apparatus.

For example, thermal interface materials are used in semiconductor devices to efficiently dissipate heat generated by electronic components. A thermal interface material is a material that reduces the thermal resistance of the path through which heat generated by a semiconductor element is released to a heat sink or a housing, etc., and is used in a variety of forms such as sheets, gels, and greases.

As the thermal interface material, those made by filling resins, such as epoxy resin or silicone resin, with thermally conductive fillers like aluminum nitride, are known.

When filling resin with a thermally conductive filler such as aluminum nitride, the thermal conductivity of the resin itself is low, therefore, a method is known in which plurality of aluminum nitride with different average particle sizes are combined to increase the filling rate of the thermally conductive filler, or make it easier to form a thermal path, thereby improving thermal conductivity.

In Patent Document 1, an invention relating to an aluminum nitride-based powder which has an average particle size D50 of 15 to 200 µm, and a content of the particles with a particle size of 5 µm or less of 60% or less based on a number, and which reduced alkaline earth metals, rare earth elements, oxygen content, and silicon content, is disclosed, and it is described that it has excellent filling ability into polymer materials.

In Patent Document 2, as an aluminum nitride powder capable of improving the thermal conductivity of heat dissipation members, an aluminum nitride powder having an average particle size of 20 to 50 µm, an oxygen content of 0.6 % by mass or less, and an average full width at half maximum of 0.095° or less for the three diffraction peaks of the Miller index (100), (002), and (101) planes obtained by X-ray diffraction, is disclosed.

In Non-Patent Document 1, filling ability to a resin, thermal conductivity, water resistance, etc., are studied for an aluminum nitride powder with an average particle size (D₅₀) of 60 µm obtained by enlarging the crystal grains using a combustion synthesis method, followed by grinding and classification, and it is described that each of these properties were good.

### CITATION LIST

### Patent Document

Patent Document 1: WO2018/216591
Patent Document 2: JP 2003-119010 A

### Non-Patent Document

Non-Patent Document 1: "Development of Large Particle Size AlN Filler by Combustion Synthesis" POLYMERS, Vol.70, No.6, 308 to 309, (2021)

### SUMMARY OF INVENTION

### TECHNICAL PROBLEM

Filling resin with the aluminum nitride disclosed in the above-described prior art improves thermal conductivity to a certain extent, resulting in good heat dissipation properties. However, with the increasing in density of power devices in recent years, even higher levels of heat dissipation properties are required. In addition, in the prior art, no detailed consideration has been given to the relationship between the surface condition or particle shape of each particle of the aluminum nitride and the thermal conductivity when filled into a resin.

Furthermore, when the filling rate of aluminum nitride in the resin is increased in order to improve the thermal conductivity, the fluidity of the resin composition itself decreases, causing a problem of poor handleability. That is, improving the thermal conductivity of a resin composition and maintaining good fluidity are generally mutually exclusive.

In the present invention, the object is to provide an aluminum nitride powder having high thermal conductivity when filled into a resin to obtain a resin composition, and good fluidity.

### SOLUTION TO PROBLEM

The present inventors have intensively studied to achieve the above object. As a result, it was found that the above-described problems can be solved by an aluminum nitride powder in which 60 vol% or more of the particles are present in the 5 to 150 µm range in all the particles in the volume-based particle size distribution measured by particle size analysis; and which satisfies specific parameters in the frequency distribution curve obtained from the particle size distribution measurement; and in which 50% or more of the particles with a particle size belonging to specific range are polyhedral particles having at least two flat surfaces, and the present invention has been completed.

A gist of the present invention is described in the following items [1] to [6].
[1] An aluminum nitride powder, containing:
   (i) 60 vol% or more of the proportion of the particles in the range of 5 to 150 µm in all the particles in the volume-based particle size distribution measured by particle size analysis; and
      having (ii) peaks in the particle size range of 5 to 50 µm (M range) and the particle size range of more than 50 µm and 150 µm or less (L range) in the frequency distribution curve obtained from the particle size distribution measurement, and having 0.2 to 1.0 of the ratio (Mᵢₙₜ/Lᵢₙₜ) of the proportion (Mᵢₙₜ) of particles in the M range to the proportion (Lᵢₙₜ) of particles in the L range,
      in which, in the scanning electron microscope image taken at 500x magnification, 50% or more of the particles with a particle size belonging to 5 to 50 µm are polyhedral particles having at least two flat surfaces.
[2] The aluminum nitride powder according to the above item [1], further containing: particles with a particle size of less than 5 µm (S range).
[3] The aluminum nitride powder according to the above item [2],
   in which the particles with a particle size of less than 5 µm (S range) are aluminum nitride particles and/or aluminum oxide particles.
[4] A resin composition containing the aluminum nitride powder according to any one of the above items [1] to [3], and a resin.
[5] A heat dissipation member containing the resin composition according to the above item [4].
[6] An electronic apparatus containing:
   the heat dissipation member according to the above item [5]; and
   an electronic device having a heat-generating part or a cooling part,
   in which the heat dissipation member is arranged in the electronic device to be in contact with the heat-generating part.

### ADVANTAGEOUS EFFECTS OF INVENTION

According to the present invention, an aluminum nitride powder having high thermal conductivity when filled into a resin to obtain a resin composition, and good fluidity, can be provided.

### BRIEF DESCRIPTION OF DRAWINGS

FIG.1 is a scanning electron microscope image of polyhedral particle present in the particle size range of 5 to 50 µm, taken at 500x magnification, in the one embodiment of the aluminum nitride powder of the present invention.
FIG. 2 is a diagram illustrating the definition of the flat surface of a particle with a particle size belonging to 5 to 50 µm contained in the aluminum nitride powder of the present invention.

### DESCRIPTION OF EMBODIMENTS

Hereinafter, an example of an embodiment of the present invention will be described in detail. However, the present invention is not limited to the embodiment described below, and can be arbitrarily modified and implemented within a range not departing from the gist of the present invention.

### [Aluminum nitride powder]

The aluminum nitride powder of the present invention contains, (i) 60 vol% or more of the proportion of the particles in the range of 5 to 150 µm in all the particles in the volume-based particle size distribution measured by particle size distribution measurement; and having (ii) peaks in the particle size range of 5 to 50 µm (M range) and particle size range of more than 50 µm and 150 µm or less (L range) in the frequency distribution curve obtained from the particle size distribution measurement, and having 0.2 to 1.0 of the ratio (Mᵢₙₜ/Lᵢₙₜ) of the proportion (Mᵢₙₜ) of particles in the M range to the proportion (Lᵢₙₜ) of particles in the L range, in which, in the scanning electron microscope image taken at 500x magnification, 50% or more of the particles with a particle size belonging to 5 to 50 µm are polyhedral particles having at least two flat surfaces.

The aluminum nitride powder of the present invention is required to contain particles in which proportion of the particles in the range of 5 to 150 µm is 60 vol% or more in all the particles in the volume-based particle size distribution measured by particle size distribution measurement. When the proportion of the particles with the above particle size range is less than 60 vol%, the filling rate of aluminum nitride in the resin becomes low, and the thermal conductivity of a resin composition containing the aluminum nitride powder decreases.

In the present invention, in order to further increase the thermal conductivity when made into a resin composition, the proportion of particles in the range of 5 to 150 µm is preferably 62 vol% or more, more preferably 64 vol% or more, and further preferably 66 vol% or more.

In this specification, the average particle size of the aluminum nitride powder means the particle size (D₅₀) at which the cumulative volume of the particles is 50% as measured by a laser diffraction particle size distribution analyzer.

The aluminum nitride powder of the present invention is required to have peaks in the particle size range of 5 to 50 µm (M range) and the particle size range of more than 50 µm and 150 µm or less (L range) in the frequency distribution curve obtained from the particle size distribution measurement, having 0.2 to 1.0 of the ratio (Mᵢₙₜ/Lᵢₙₜ) of the proportion (Mᵢₙₜ) of particles in the M range to the proportion (Lᵢₙₜ) of particles in the L range. When the proportion ratio (Mᵢₙₜ/Lᵢₙₜ) is less than 0.2, the fluidity decreases. On the other hand, when it exceeds 1.0, the thermal conductivity of the aluminum nitride in the resin composition decreases.

In order to further increase the thermal conductivity and fluidity of the resin composition, the above-described ratio (Mᵢₙₜ/Lᵢₙₜ) is preferably 0.3 to 0.9, more preferably 0.35 to 0.85, and further preferably 0.4 to 0.8.

In the present invention, the particle size distribution and the frequency distribution curve are measured by a laser diffraction scattering method.

The shape of aluminum nitride particles belonging to the L range is not particularly limited, and those having known shapes such as irregularly shaped and spherical shapes can be used without particular limitation. That is, the above-described particles with larger particle sizes have a larger curvature radius of the particle surface, and they effectively act in surface contact with the polyhedral aluminum nitride particles belonging to the M range, as described below. As the shape of aluminum nitride particles belonging to the L range, those having a polyhedral shape which will be described in detail for aluminum nitride powder belonging to the M range can be used.

The aluminum nitride particles that correspond to the above L range and have a particle size of more than 50 µm and 150 µm or less as measured by observation with a scanning electron microscope at 500x magnification are preferably those having an aspect ratio (a ratio (L/D) of the major axis (L) to the minor axis (D)) of 1 to 1.5 from the viewpoint of fluidity. The above-described aspect ratio is more preferably 1 to 1.4, and further preferably 1 to 1.3.

The aspect ratio is a value determined by observing aluminum nitride particles with a particle size of more than 50 µm and 150 µm or less in the aluminum nitride powder using a scanning electron microscope at 500x magnification, as described above. The major axis (L) is defined as the maximum distance between two arbitrary points on the perimeter of the aluminum nitride particles. The minor axis (D) is defined as a line segment that intersects the major axis (L) perpendicularly and runs through the midpoint of the major axis (L) and two points on the perimeter of the aluminum nitride particles.

The average value of the ratio (L/D) of the major axis (L) to the minor axis (D) is calculated by measuring the ratio (L/D) for at least 20 or more of aluminum nitride powder particles belonging to L range, and averaging these.

Here, aluminum nitride particles with a particle size belonging to the range of more than 50 µm and 150 µm or less, identified by a scanning electron microscope image, refer to aluminum nitride particles having a major axis (L) in the range of more than 50 µm and 150 µm or less in an image of the aluminum nitride powder of the present invention observed with a scanning electron microscope.

### <Particles in the M range>

In the present invention, it is required that in the scanning electron microscope images taken at 500x magnification, 50% or more of the particles with a particle size belonging to 5 to 50 µm are polyhedral particles having at least two flat surfaces.

In the aluminum nitride powder of the present invention, the proportion of polyhedral particles with a particle size belonging to 5 to 50 µm is the proportion of the total area of the polyhedral particles to the total area of all aluminum nitride particles with a particle size in the range of 5 to 50 µm as identified in the above-described scanning electron microscope image.

Here, aluminum nitride particles with a particle size belonging to the range of 5 to 50 µm, identified by a scanning electron microscope image, refer to aluminum nitride particles having a major axis (L) in the range of 5 to 50 µm or less in an image of the aluminum nitride powder of the present invention observed with a scanning electron microscope.

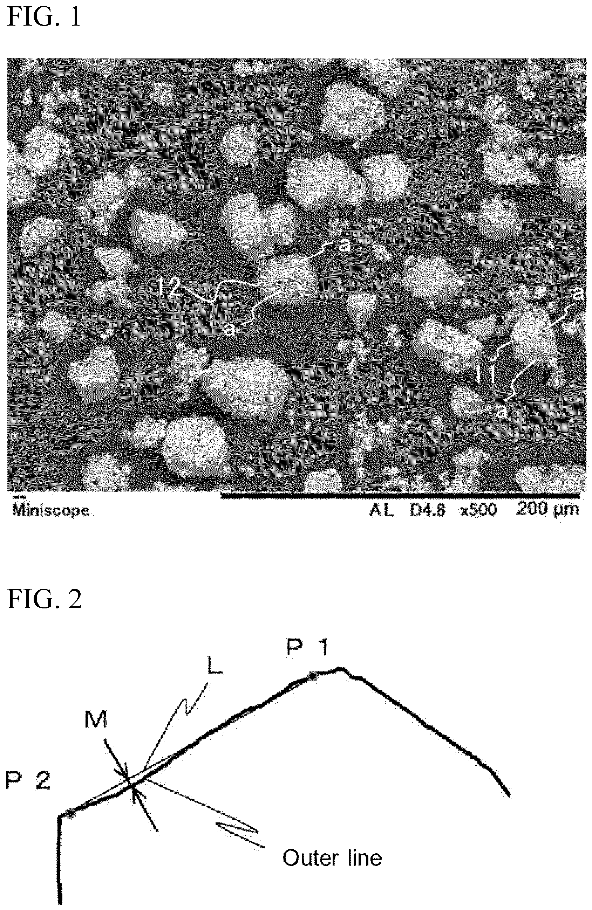

In FIG. 1, a scanning electron microscope image of polyhedral particle present in the particle size range of 5 to 50 µm, taken at 500x magnification, in the one embodiment of the aluminum nitride powder of the present invention, is shown.

The polyhedral particles 11 have a polyhedral shape where plural flat surfaces 'a' are randomly present, and are aluminum nitride particles having at least two flat surfaces 'a'. Similarly, the polyhedral particles 12 are aluminum nitride particles having at least two flat surfaces 'a'. In FIG. 1, in addition to the polyhedral particle 11 and the polyhedral particle 12, a plurality of polyhedral particles is present.

Moreover, the flat surface 'a' provided on the polyhedral particle is different from a fractured surface formed by pulverizing aluminum nitride. That is, in the present invention, the flat surface 'a' is a smooth and flat surface on which no irregular structure or undulations are observed, as shown in FIG. 1. In the present invention, the term "flat surface" means a smooth, flat surface. Suitable aluminum nitride having such a flat surface can include, for example, aluminum nitride having a flat surface derived from the crystal growth plane of the aluminum nitride, and such aluminum nitride has a smoother and flatter smooth surface derived from the crystal growth plane.

In contrast, since the fractured surface has poor smoothness compared with the flat surface, and an irregular structure and undulation derived from the pulverizing can be confirmed by observation with a scanning electron microscope, it can be distinguished from the flat surface of the present invention. Furthermore, the flat surface 'a' is preferably smoother and flatter, in other words, the higher the smoothness is, the more desirable it is. For example, as will be described in more detail in the Examples, in a SEM image at 2000x of the cross-section of the particles, for 10 arbitrarily selected particles, the maximum value of the perpendicular distance between the outer line corresponding to the flat surface and a straight line connecting the ends of the outer line is denoted as M, and among the measured values of M for each of the 10 selected particles, the largest value Mₘₐₓ is preferably 0.3 µm or less, and more preferably 0.2 µm or less. The average value M_{A} of M for 10 particles is further preferably 0.15 µm or less.

Note that for the fractured surface generated by crushing a bulk material of aluminum nitride lumps, the Mₘₐₓ is not become smaller than 0.3 µm including irregularity and undulation, even on a smooth surface, and the average value M_{A} of the maximum values is not become smaller than 0.15 µm.

The polyhedral particles shown in FIG. 1 sufficiently satisfy the above-described characteristics.

As the aluminum nitride particles having at least two of the flat surfaces 'a', known particles, for example, polyhedral particles described in WO 2017/131239, etc., can be used without particular limitation, and it is particularly preferable that the flat surface 'a' is the one derived from the crystal growth plane of aluminum nitride.

In the present invention, since 50% or more of the particles with a particle size belonging to 5 to 50 µm are polyhedral particles, the thermal conductivity of the resin composition is improved when filled into a resin. The reason for this is unclear, but it is considered that the presence of 50% or more of polyhedral particles having multiple flat surfaces in the 5 to 50 µm particle size range increases the contact area between particles when combined with particles belonging to the particle size range of more than 50 µm and 150 µm or less in the resin, and this facilitates the formation of thermal conduction paths. In addition, the presence of flat surfaces on the particles with a particle size belonging to 5 to 50 µm improves the fluidity of the particles, which can contribute to improving the filling ability when filled into a resin.

The above-described effect can be more effectively achieved when preferably 55% or more, more preferably 60% or more, further preferably 65% or more, further more preferably 70% or more, and particularly preferably 80% or more of the particles with a particle size belonging to 5 to 50 µm are polyhedral particles having at least two flat surfaces.

As described above, the flat surfaces provided on the polyhedral particles are different from the fractured surfaces, which have irregularity and undulation. In the particle size range of 5 to 50 µm, when there are fewer particles having fractured surfaces and a certain proportion of polyhedral particles are present, the fluidity of the resin composition filled into the resin tends to improve. While not bound to a specific theory, when the proportion of particles having fractured surfaces is low and a certain proportion of polyhedral particles are present, it is considered that particles with particle sizes of more than 50 µm and 150 µm or less, as well as the particles with a particle size in the range of 5 to 50 µm range, roll on the smooth and flat surfaces of the polyhedral particles, reducing overall flow resistance and thus tending to improve fluidity. On the other hand, it is considered that, when the proportion of particles having fractured surfaces is high, it might create resistance to rolling and thus reduce fluidity.

From the above, the aluminum nitride powder of the present invention can achieve both improved thermal conductivity when filled into a resin to form a resin composition and good fluidity by having the above-described characteristics in particles with a particle size belonging to 5 to 50 µm.

From the above-described reason, the presence proportion of the particles having a fractured surface in the aluminum nitride powder of the present invention is preferably 20 % or less, more preferably 10 % or less.

The presence proportion of particles having a fractured surface is the proportion of the total area of particles having a fractured surface to the total area of all aluminum nitride particles identified in an image observed under a scanning electron microscope at 500x magnification.

The number of flat surfaces provided on the polyhedral particle is not particularly limited as long as it is two or more. From the viewpoint of increasing the contact area between particles when filled into a resin, the number is preferably three or more. The upper limit of the flat surfaces provided on the polyhedral particle is not particularly limited, and it is for example 10. In addition, it is preferable that the two consecutive flat surfaces are continuous so as to form an edge portion.

The number of flat surfaces provided on the polyhedral particle is determined based on an image captured by a scanning electron microscope (SEM) observation at 500x magnification.

The area of the individual flat surfaces provided on the polyhedral particles is preferably large by a certain degree from the viewpoint of increasing the contact area between particles when filled into the resin to improve thermal conductivity. From this viewpoint, it is preferable that the polyhedral particles have at least two flat surfaces with an area of 2 to 1600 µm², and it is more preferable that they have at least three flat surfaces with an area of 2 to 1600 µm².

Note that the area of flat surface is determined by an image captured by a scanning electron microscope (SEM) observation at 500x magnification.

The average value of the ratio (L/D) of the major axis (L) to the minor axis (D) for aluminum nitride particles belonging to the particle size range of 5 to 50 µm is preferably 1 to 1.4, more preferably 1 to 1.3, and further preferably 1.0 to 1.2. When the ratio (L/D) is within the above range, it is possible to maintain good fluidity of the resin composition in which the resin is filled with the aluminum nitride powder can be maintained good, therefore the handling properties are excellent.

The major axis (L) and minor axis (D) of particles belonging to the particle size range of 5 to 50 µm can be determined by observing aluminum nitride particles with a particle size of 5 to 50 µm in the aluminum nitride powder using a scanning electron microscope at 500x magnification.

The major axis (L) is defined as the maximum distance between two arbitrary points on the perimeter of the aluminum nitride particles. The minor axis (D) is defined as a line segment that intersects the major axis (L) perpendicularly and runs through the midpoint of the major axis (L) and two points on the perimeter of the aluminum nitride particles.

The average value of the ratio (L/D) of the major axis (L) to the minor axis (D) is calculated by measuring the ratio (L/D) for at least 20 or more of aluminum nitride particle powder belonging to the above-described particle size range, and averaging these.

Note that the aluminum nitride particles with a particle size belonging to the range of 5 to 50 µm containing polyhedral particles can be obtained, for example, by the manufacturing method described below.

The oxygen content of the particles belonging to the M range of the aluminum nitride powder of the present invention is preferably 0.5 % by mass or less, since this imparts high thermal conductivity to the particles themselves. Here, the oxygen content is the total amount of oxygen measured by a high temperature pyrolysis method described in the Examples.

When the oxygen content is 0.5 % by mass or less, the particles belonging to the M range can maintain high thermal conductivity, and the resin composition containing the aluminum nitride powder also has high dissipation properties.

The oxygen content is more preferably 0.4 % by mass or less, further preferably 0.3 % by mass or less, and furthermore preferably 0.2 % by mass or less.

It is preferable that the aluminum nitride powder of the present invention further contains particles with a particle size of less than 5 µm (S range) (hereinafter, sometimes referred to as "small particles"). By containing particles of the S range, the fluidity of the resin composition can be further improved.

Although the reason why the fluidity of the aluminum nitride powder as a whole is improved by further containing the particles of the S range is not certain, it is speculated as follows. That is, it is considered that the small particles fill the spaces between the aluminum nitride particles with a particle size range belonging to the L and M ranges, which relatively increases the resin component contributing to fluidity, thereby further improving the fluidity as a whole.

As described above, the particle size of small particles having a peak in the S range is 4.5 µm or less, more preferably 4 µm or less, further preferably 3.5 µm or less, and furthermore preferably 3 µm or less. The lower limit of the particle size of the small particles is not particularly limited, and is preferably 0.05 µm, more preferably 0.1 µm, and further preferably 0.15 µm.

A part or all of the small particles may be made of a material other than aluminum nitride, for example, alumina.

The small particles that may be contained in the aluminum nitride powder of the present invention are not particularly limited. For example, the particles may be aluminum nitride particles having the above particle size, or may be particles such as aluminum oxide particles, calcium oxide particles, yttrium oxide, zinc oxide, silica, silicon nitride. Among these, it is preferable that the small particles are aluminum nitride particles and/or aluminum oxide particles.

The content of the small particles in the aluminum nitride powder is not particularly limited as long as it is less than 40 vol%, and is preferably 35 vol% or less, and further preferably 30 vol% or less. By having the amount of small particles within the above range, it is possible to achieve extremely good fluidity while maintaining high thermal conductivity of the resin composition when filled into a resin.

### [Method for producing aluminum nitride powder]

The method for producing aluminum nitride powder of the present invention is not particularly limited as long as it is possible to obtain an aluminum nitride powder containing (i) 60 vol% or more of the proportion of the particles in the range of 5 to 150 µm in all the particles in the volume-based particle size distribution measured by particle size distribution measurement; and having (ii) peaks in the particle size range of 5 to 50 µm (M range) and the particle size range of more than 50 µm and 150 µm or less (L range) in the frequency distribution curve obtained from the particle size distribution measurement, and having 0.2 to 1.0 of the ratio (Mᵢₙₜ/Lᵢₙₜ) of the proportion (Mᵢₙₜ) of particles in the M range to the proportion (Lᵢₙₜ) of particles in the L range, in which, in the scanning electron microscope images taken at 500x magnification, 50% or more of the particles with a particle size belonging to 5 to 50 µm are polyhedral particles having at least two flat surfaces. For example, the aluminum nitride powder of the present invention can be obtained by mixing an aluminum nitride powder having a peak in the above-described L range with an aluminum nitride powder having a peak in the M range and in which the particles with a particle size belonging to 5 to 50 µm contain polyhedral particles, such that the ratio after mixing (Mᵢₙₜ/Lᵢₙₜ) satisfies the above-described range. During mixing, the small particles can be mixed.

As the aluminum nitride powder belonging to each range of average particle size, any commonly used powder may be used without any particular limitation, as long as it has a predetermined average particle size. For example, it may be one produced by a reduction nitridation method, or it may be one produced by a direct nitriding method such as a combustion synthesis method and then adjusted to a predetermined average particle size through a pulverizing and classification process, or it may be one produced by a manufacturing method other than these.

An example of a method for producing an aluminum nitride powder having a peak in the M range in a frequency distribution curve and containing polyhedral particles belonging to 5 to 50 µm can be a manufacturing method having the following steps 1 and 2.

Step 1: A step of mixing 100 parts by mass of a first aluminum nitride powder raw material with 0.5 to 5 µm and a specific surface area of 1.2 to 16.0 m²/g with 1 to 20 parts by mass of a second aluminum nitride powder raw material with an average particle size of 3 to 40 µm, a specific surface area of 0.05 to 1.8 m²/g, and a ratio (SA2/SA1) of the specific surface area (SA2) relative to the specific surface area (SA1) of the first aluminum nitride powder raw material of 0.8 or less, to prepare a raw material mixture

Step 2: A step of heating the raw material mixture to 1750 to 2100 °C while supplying an inert gas

### <Step 1>

Step 1 is a step of mixing 100 parts by mass of a first aluminum nitride powder raw material with 0.5 to 5 µm and a specific surface area of 1.2 to 16.0 m²/g with 1 to 20 parts by mass of a second aluminum nitride powder raw material with an average particle size of 3 to 40 µm, a specific surface area of 0.05 to 1.8 m²/g, and a ratio (SA2/SA1) of the specific surface area (SA2) relative to the specific surface area (SA1) of the first aluminum nitride powder raw material of 0.8 or less, to prepare a raw material mixture.

By containing aluminum nitride with different average particle sizes in predetermined blending amounts in the raw material mixture, and by subjecting it to a heating step (step 2) described below, the aluminum nitride powder containing polyhedral particles having at least two flat surfaces can be obtained.

Note that the specific surface area of each of the raw material powders can be determined, for example, by the BET method using N₂ adsorption with flow-type automatic surface area analyzer, FlowSorb 2300, manufactured by SHIMADZU CORPORATION.

It is considered that by having an appropriate amount of the second aluminum nitride powder raw material with a relatively large average particle size, during the heating step, the first aluminum nitride powder raw material with a small average particle size is incorporated into the second aluminum nitride powder raw material through a sublimation reaction, causing the second aluminum nitride powder raw material to undergo crystal growth, resulting in an increase in particle size. It is presumed that the above-described predetermined polyhedral particles are formed by such crystal growth. Furthermore, it is presumed that since the oxygen present in the first aluminum nitride powder is effectively removed by the above-described sublimation reaction, the polyhedral particles of the aluminum nitride powder produced through the heating step has a low oxygen content.

As described above, by using the first and second aluminum nitride powder raw materials in combination in a predetermined blending amount, the crystal growth proceeds sufficiently and aggregation of particles can be suppressed.

The first aluminum nitride powder raw material has an average particle size of 0.5 to 5 µm and a specific surface area of 1.2 to 16.0 m²/g, and preferably has an average particle size of 0.7 to 5 µm and a specific surface area of 1.2 to 12.0 m²/g.

The second aluminum nitride powder raw material has an average particle size of 3 to 40 µm and a specific surface area of 0.05 to 1.8 m²/g. The average particle size of the second aluminum nitride powder raw material may be appropriately selected depending on the desired average particle size, and is preferably 3 to 20 µm, more preferably 5 to 15 µm.

In the raw material mixture, the blending amount of the second aluminum nitride powder raw material with respect to 100 parts by mass of the first aluminum nitride powder raw material is preferably 1 to 20 parts by mass, more preferably 2 to 15 parts by mass, and further preferably 3 to 10 parts by mass. As described above, by appropriately adjusting the blending amounts of the first and second aluminum powder raw materials, it becomes easier to obtain aluminum nitride powder with an average particle size of 5 to 50 µm (having a peak in the M range in the frequency distribution curve) and containing polyhedral particles.

The ratio (SA2/SA1) of the specific surface area (SA2) of the second aluminum nitride powder raw material to the specific surface area (SA1) of the first aluminum nitride powder raw material is preferably 0.8 or less. By adjusting the ratio of the specific surface areas (SA2/SA1), a resin composition having a higher thermal conductivity can be obtained. While not bound to a specific theory, it is considered that by setting the specific surface area ratio as described above, a larger proportion of the forms of the particles with a particle size belonging to the 5 to 50 µm can be polyhedral particles, and therefore, as described above, this increases the contact area between particles when the resin composition is filled, facilitating the formation of thermal conduction paths. The above-described ratio of the specific surface areas (SA2/SA1) is more preferably 0.7 or less, and further preferably 0.6 or less. The lower limit of the ratio of specific surface areas (SA2/SA1) is not particularly limited, and is, for example, 0.005.

The raw material mixture may contain additives for forming a liquid phase and additives for promoting grain growth during firing. As the additive, oxides of alkali metals, alkaline earth metals or rare earth elements are generally known, and yttrium oxide is a typical example.

The content of the additive in the raw material mixture is preferably about 1 to 10 % by mass.

As the aluminum nitride powder of first and second aluminum nitride powder raw material, any commonly used powder may be used without any particular limitation, as long as it has a predetermined average particle size. For example, it may be one produced by a reduction nitridation method, or it may be one produced by a direct nitriding method such as a combustion synthesis method and then adjusted to a predetermined average particle size through a pulverizing and classification process, or it may be one produced by a manufacturing method other than these. Among these, the first and second aluminum nitride powder raw materials are preferably produced by a reduction nitridation method, since it does not require a pulverizing and classification process.

It is also preferable to use the aluminum nitride powder produced by steps 1 and 2 as a second aluminum nitride powder raw material and perform steps 1 and 2 again to obtain aluminum nitride powder having a larger average particle size.

### <Step 2>

Step 2 is a step of heating the raw material mixture prepared in the step 1 to 1750 to 2100 °C while supplying an inert gas.

By setting the heating temperature to 1750 °C or higher, the crystal growth of the aluminum nitride particles is promoted, and it becomes easier to obtain aluminum nitride powder containing aluminum nitride particles having smooth flat surfaces (smooth surfaces). On the other hand, by setting the heating temperature to 2100 °C or less, aggregation due to fusion between particles can be suppressed. From these viewpoints, the heating temperature is preferably from 1750 to 2100 °C, more preferably from 1800 to 2050 °C, and further preferably from 1800 to 2000 °C.

A heating time is not particularly limited, and it is preferably 1 to 20 hours, more preferably 2 to 15 hours. When the heating time is 1 hour or longer, the crystal growth of the aluminum nitride particles proceeds sufficiently, and a smooth flat surface is likely to be formed. On the other hand, even when heating is performed for more than 20 hours, grain growth becomes difficult to proceed, and there is no advantage in industrial practice.

The heating is performed under supply of an inert gas. That is, an embodiment in which an inert gas is supplied into a heating device for placing and heating the raw material mixture is most preferred, however it is also possible to heat the raw material mixture while continuously supplying the inert gas. The raw material mixture is filled in a heating device (hereinafter also referred to as a "setter") and placed in the heating device, and as the setter, those made of carbon are preferably used. As the inert gas, argon gas or nitrogen gas can be used, with nitrogen gas being preferred.

### <Other steps>

After step 2, a disintegrating step may be performed as necessary. Disintegrating is performed in order to break apart the loosely bonded aluminum nitride particles, and it differs from pulverizing in which the aluminum nitride particles are partially fractured. Therefore, even when a disintegrating step is performed, the shape of the above-described polyhedral particles is maintained, and very few particles having fractured surfaces are produced.

Disintegrating can be performed using known methods, for example, by using a roll crusher mill, jet mill, ball mill, masscolloider, or jaw crusher.

Furthermore, an oxidation step may also be performed after step 2, and it is preferable to perform the oxidation step after the above-mentioned disintegrating step. By performing the oxidation step, decomposition due to contact with water or the like can be prevented.

The oxidation step can be performed by heating in air atmosphere. The heating temperature in the oxidation step is not particularly limited, and is preferably 500°C to 900°C, more preferably 600°C to 800°C. A heating time is not particularly limited, and it is preferably 1 to 20 hours, more preferably 5 to 15 hours.

The oxygen content of the oxide film formed in the above-described oxidation step is included in the oxygen content of the aluminum nitride powder. By performing the oxidation step so that the oxygen content does not exceed the range of the oxygen content of the aluminum nitride powder as described above, it is possible to impart excellent thermal conductivity to the resulting resin composition when filled into a resin.

The aluminum nitride powder of the present invention may be subjected to a surface treatment as necessary for the purpose of improving compatibility with resins, water resistance, and the like. As the surface treatment, known methods can be employed. The surface treatment can be performed using, for example, organic silicon compounds such as silicone oil, silylating agents, and silane coupling agents; acids such as phosphoric acid, phosphates, and fatty acids; polymer compounds such as polyamide resins; and inorganic substances such as alumina and silica.

### <Applications>

The applications of the aluminum nitride powder of the present invention are not particularly limited. It can be used as a raw material for aluminum nitride substrates, it is preferably used for resin filling. It is preferable that a resin is filled with the aluminum nitride powder of the present invention and used as a resin composition containing the resin and the aluminum nitride powder. By containing particles with specific particle size ranges and by the fact that 50 % or more of the particles with specific ranges are polyhedral particles having at least two flat surfaces, the aluminum nitride powder of the present invention achieves high thermal conductivity when filled into a resin composition and has excellent fluidity. As described above, since the contact area between particles in the aluminum nitride powder is large, it is easy to effectively form a thermal conduction path in the resin composition, and the aluminum nitride powder can be suitably used as a heat dissipation member (heat dissipation material).

The resin contained in the resin composition is not particularly limited, and examples thereof include thermosetting resins such as epoxy resins, epoxy resins having a mesogen group introduced therein, unsaturated polyester resins, polyimide resins, and phenolic resins; thermoplastic resins such as polyethylene, polypropylene, polyamide, polycarbonate, and polyphenylene sulfide; rubbers such as ethylene propylene rubber and styrene butadiene rubber; and silicone resins. Among these, epoxy resins and silicone resins are preferred.

The content of the aluminum nitride powder of the present invention contained in the resin composition is not particularly limited, and is preferably 300 to 5000 parts by mass, and more preferably 400 to 5000 parts by mass, with respect to 100 parts by mass of the resin. When the content of aluminum nitride powder is equal to or more than these lower limits, the thermal conductivity of the resin composition is improved, and when the content of aluminum nitride powder is equal to or less than these upper limits, the fluidity of the resin composition is increased, and the handleability, such as moldability, is improved.

The resin composition may contain other fillers other than the aluminum nitride powder of the present invention, as long as the effects of the present invention are not impaired.

Examples of the other fillers include aluminum nitride powder, which does not satisfy the requirements of the present invention, as well as alumina, zinc oxide, boron nitride, silicon nitride, silicon carbide, and graphite.

The mixing ratio of the aluminum nitride powder of the present invention to other fillers can be appropriately adjusted within the range of 1:99 to 99: 1.

The resin composition may contain additives such as a plasticizer, a vulcanizing agent, a curing accelerator, and a release agent, as necessary.

The resin composition can be produced by mixing each components by a blender or a mixer. The resin composition obtained in such a manner can be made into a heat dissipation member (heat dissipation material) of a desired form, such as a heat dissipation sheet or heat dissipation grease, by a known molding method. Examples of molding methods include extrusion molding, press molding, doctor blade method, and resin impregnation method, and thermal curing or light curing may be performed after the molding process, as needed.

In one embodiment of the present invention, an electronic apparatus including the heat dissipation member and an electronic device having a heat-generating part or a cooling part, in which the heat dissipation member is arranged in the electronic device to be in contact with the heat-generating part, can be provided.

### EXAMPLES

Hereinafter, Examples are shown to more specifically describe the present invention, but the present invention is not limited to these Examples.

### [Measurement Methods]

Various physical properties in the examples and comparative examples were measured by the following methods.

### (1) Particle size distribution measurement

The particle size distribution was measured based on a volume using a laser diffraction particle size distribution analyzer ("MICROTRAC HRA" manufactured by MicrotracBEL Corp.) after dispersing the aluminum nitride powder in a solution made by adding a 5% sodium pyrophosphate aqueous solution to 90 mL of water and then dispersing the mixture with a homogenizer.

### (2) The ratio (Mᵢₙₜ/Lᵢₙₜ) of the proportion of particles in the M range (Mᵢₙₜ) to the proportion of particles in the L range (Lᵢₙₜ)

For the aluminum nitride powder, the particle size distribution was measured using the method described in (1) above, and based on the measurement data, a frequency distribution curve with frequency distribution on the vertical axis and particle size on the horizontal axis was obtained. In cases where there are peaks in the particle size range of 5 to 50 µm (M range) and the particle size range of more than 50 µm and 150 µm or less (L range) respectively, the ratio (Mᵢₙₜ/Lᵢₙₜ) of the proportion of particles in the M range (Mᵢₙₜ) to the proportion of particles in the L range (Lᵢₙₜ) was determined.

### (3) Presence or absence and Presence Proportion of Polyhedral particles

For the aluminum nitride powder, SEM images were taken using a scanning electron microscope (Hitachi High-Technologies Corporation model 'TM3030') at 500x magnification (accelerating voltage of 15 kV, secondary electron detection). From the SEM images, the presence or absence of the particles having two or more flat surfaces among the aluminum nitride powder belonging to the M range in the frequency distribution curve was confirmed, and the presence or absence of polyhedral particles was judged. The field number in the SEM images should be ten or more.

The presence proportion of polyhedral particles was calculated from image analysis of the above SEM images by determining the ratio of the total area of polyhedral particles to the total area of all aluminum nitride particles with a particle size belonging to 5 to 50 µm, and this ratio was defined as the presence proportion of polyhedral particles. Specifically, it was calculated using the following formula. Presence Proportion (%) of polyhedral particles = [(total area of polyhedral particles) / (total area of all aluminum nitride particles with a particle size belonging to a particle size range of 5 to 50 µm)] × 100

### (4) Evaluation of Flat surface

After filling the aluminum nitride powder into acrylic resin and curing it, a cut was made at an arbitrary location. In the SEM image of the cross-section at 2000x magnification, 10 arbitrary particles having flat surfaces were selected. As shown in Figure 2, a line L was drawn connecting the endpoints P1 and P2 of the outer line that forms the flat surface. The maximum value of the perpendicular distance between the above-described line L and the outer line was denoted as M. Among the measured values of M for each of the above-described 10 selected particles, the largest value was denoted as Mₘₐₓ. Further, the average value of M was shown as M_{A}.

### (5) The ratio (L/D) of Major axis (L) to Minor axis (D) of particles

For the aluminum nitride powder, SEM images were taken using a scanning electron microscope (Hitachi High-Technologies Corporation model 'TM3030') at 500x magnification (accelerating voltage of 15 kV, secondary electron detection). From the SEM image taken, the ratio of the major axis (L) to the minor axis (D) was determined for aluminum nitride particles with a particle size of the above described specific ranges, and these were averaged to obtain the ratio (L/D) of the major axis (L) to the minor axis (D) of the polyhedral particles.

### (6) Oxygen content

The oxygen content of the aluminum nitride powder was measured using an oxygen and nitrogen analyzer "EMGA-620W" manufactured by Horiba, Ltd., based on the amount of CO gas generated by high temperature pyrolysis method in a graphite crucible, and the oxygen content (oxygen concentration) contained in the aluminum nitride powder was measured.

The oxygen concentration of the powder belonging to the M range in the frequency distribution curve was measured after separating the aluminum nitride powder with particle sizes corresponding to the above range using a sieve.

### (7) Thermal conductivity of Resin Composition

A resin composition was obtained by mixing aluminum nitride powder and silicone resin. The resin composition was hot pressed at 100 °C to obtain a sheet having a thickness of 7 mm. The thermal conductivity of the obtained sheet was measured using a Hot Disk method thermal properties measurement device (TPS500, manufactured by Kyoto Electronics Manufacturing Co., Ltd.).

### (8) Fluidity of Resin composition

For the resin composition obtained in (7) above, the discharge volume per minute (g/min) was measured using a syringe "PSY-30F" manufactured by Musashi Engineering Co., Ltd.

The inner diameter of the body part of the syringe for storing the sample was 22 mm, and the inside diameter of the tip part for discharging the sample was 2 mm. The discharge pressure was set to 0.62 Pa.

### [Raw materials used]

The following raw materials were used.
"Aluminum nitride raw material having a peak in the L range in the frequency distribution curve"

Aluminum nitride powder (L-AlN) with an average particle size of 120 µm produced by reduction nitridation method (hereinafter, in the examples, it will be described as "particles belonging to the L range" or "L range particles")
"Aluminum nitride raw material having a peak in the M range in the frequency distribution curve"

Aluminum nitride powder obtained by the following synthesis method (hereinafter, in the examples, it will be described as "particles belonging to the M range" or "M range particles") "Small particles (S-1) having a peak in the S range in the frequency distribution curve"

Aluminum nitride powder with an average particle size of 1 µm (hereinafter, in the examples, it will be described as "particles belonging to the S range (S-1)" or "S range particles (S-1)")
"Small particles (S-2) having a peak in the S range in the frequency distribution curve"

Aluminum oxide with an average particle size of 0.3 µm (hereinafter, in the examples, it will be described as "particles belonging to the S range (S-2)" or "S range particles (S-2)")

### (Synthesis Example 1)

A raw material mixture was prepared by mixing 100 parts by mass of aluminum nitride powder raw material having an average particle size of 0.5 µm and a specific surface area of 15.70 m²/g and 10 parts by mass of aluminum nitride powder raw material having an average particle size of 7.8 µm and a specific surface area of 0.62 m²/g.

The raw material mixture was placed in a heating device, nitrogen gas was supplied into the device to create a nitrogen atmosphere, and was heated at 2000 °C for 5 hours. Heating was performed under normal pressure, followed by disintegrating and oxidation treatment, to obtain aluminum nitride powder (M-AIN1) with an average particle size of 18.7 µm and a specific surface area of 0.20 m²/g.

The oxygen content of the obtained M-AlN1 was 0.14 % by mass. Moreover, Mₘₐₓ on the flat surface was 0.17 µm, and M_{A} was 0.05 µm.

### (Synthesis Example 2)

A raw material mixture was prepared by mixing 100 parts by mass of aluminum nitride powder raw material having an average particle size of 0.5 µm and a specific surface area of 15.70 m²/g, 5 parts by mass of aluminum nitride powder raw material having an average particle diameter of 16.2 µm and a specific surface area of 0.23 m²/g, and 0.1 parts by mass of calcium fluoride as an additive.

The raw material mixture was placed in a heating device, nitrogen gas was supplied into the device to create a nitrogen atmosphere, and was heated at 1900 °C for 18 hours. Heating was performed under normal pressure, followed by disintegrating and oxidation treatment, to obtain aluminum nitride powder (M-AIN2) with an average particle size of 26.3 µm and a specific surface area of 0.19 m²/g. The oxygen content of the obtained M-AlN2 was 0.11 % by mass. Moreover, Mₘₐₓ on the flat surface was 0.16 µm, and M_{A} was 0.07 µm.

### Example 1

The aluminum nitride powder was prepared by mixing aluminum nitride raw material belonging to the L range (L-AlN) and aluminum nitride raw material belonging to the M range (M-AlN1) in a ratio (Mᵢₙₜ/Lᵢₙₜ) as shown in Table 1.

The obtained aluminum nitride powder and silicone resin were mixed using a blade-type mixer to prepare the resin composition.

Specifically, as the above resin, a mixture was prepared by mixing both-terminated vinyl silicone and a polyorganosiloxane having a hydrosilyl group in a mass ratio of 97:3. To this mixture, 20 ppm in terms of platinum element of platinum catalyst (1,2-divinyltetramethyldisiloxane complex of platinum) and 300 ppm of 1-ethynyl-1-cyclohexanol were added. This mixture (viscosity at 25°C: 100 mPa·s) was then combined with decyltrimethoxysilane to prepare a mixture as the base resin.

Next, the base resin and aluminum nitride powder were mixed with a blade-type mixer so that the filling rate of the aluminum nitride powder was 75 vol% to prepare a resin composition.

The thermal conductivity and fluidity of the resulting resin composition were measured. The results are shown in Table 1.

### Example 2

An aluminum nitride powder and a resin composition containing the aluminum nitride powder were obtained in the same manner as in Example 1, except that particles belonging to the S range (S-1) were used, the filling rate of the aluminum nitride powder was set to 82 vol%, and the mixing ratio was changed as shown in Table 1. The measurement results of the thermal conductivity and fluidity of the resulting resin composition were shown in Table 1.

### Example 3

An aluminum nitride powder and a resin composition containing the aluminum nitride powder were obtained in the same manner as in Example 1, except that M-AlN2 was used as the aluminum nitride raw material belonging to the M range, particles (S-1) and (S-2) belonging to the S range were used so that the proportion of (S-2) in the S range particles was 50 vol%, and the mixing ratio was changed as shown in Table 1. The measurement results of the thermal conductivity and fluidity of the resulting resin composition were shown in Table 1.

### Example 4

An aluminum nitride powder and a resin composition containing the aluminum nitride powder were obtained in the same manner as in Example 3, except that M-AlN1 was used as the aluminum nitride raw material belonging to the M range, and the proportions of the L range particles and the M range particles were changed to the proportions shown in Table 1 so that the Mᵢₙₜ/Lᵢₙₜ ratio was the proportion shown in Table 1. The measurement results of the thermal conductivity and fluidity of the resulting resin composition were shown in Table 1.

### Example 5

An aluminum nitride powder and a resin composition containing the aluminum nitride powder were obtained in the same manner as in Example 2, except that the proportions of the L range particles and the M range particles were changed to the proportions shown in Table 1 so that the Mᵢₙₜ/Lᵢₙₜ ratio was the proportion shown in Table 1. The measurement results of the thermal conductivity and fluidity of the resulting resin composition were shown in Table 1.

### Comparative example 1

An aluminum nitride powder and a resin composition containing the aluminum nitride powder were obtained in the same manner as in Example 1, except that a commercially available aluminum nitride powder having substantially no flat surface was used as the aluminum nitride powder constituting the M range. The measurement results of the thermal conductivity and fluidity of the resulting resin composition were shown in Table 1.

### Comparative example 2

An aluminum nitride powder and a resin composition containing the aluminum nitride powder were obtained in the same manner as in Example 1, except that the proportions of the L range particles and the M range particles were changed to the proportions shown in Table 1 so that the Mᵢₙₜ/Lᵢₙₜ ratio was the proportion shown in Table 1. The measurement results of the thermal conductivity and fluidity of the resulting resin composition were shown in Table 1.

### Comparative example 3

An aluminum nitride powder and a resin composition containing the aluminum nitride powder were obtained in the same manner as in Example 1, except that the proportions of the L range particles and the M range particles were changed to the proportions shown in Table 1 so that the Mᵢₙₜ/Lᵢₙₜ ratio was the proportion shown in Table 1. The measurement results of the thermal conductivity and fluidity of the resulting resin composition were shown in Table 1.

### Comparative examples 4 and 5

An aluminum nitride powder and a resin composition containing the aluminum nitride powder were obtained in the same manner as in Example 2, except that the proportions of the L range particles and the M range particles were changed to the proportions shown in Table 1 so that the Mᵢₙₜ/Lᵢₙₜ ratio was the proportion shown in Table 1. The measurement results of the thermal conductivity and fluidity of the resulting resin composition were shown in Table 1.

### Comparative example 6

An aluminum nitride powder and a resin composition containing the aluminum nitride powder were obtained in the same manner as in Example 2, except that the proportions of the L range particles and the M range particles were changed to the proportions shown in Table 1 so that the Mᵢₙₜ/Lᵢₙₜ ratio was the proportion shown in Table 1, and the proportion of S range particles was changed to the proportions shown in Table 1. The measurement results of the thermal conductivity and fluidity of the resulting resin composition were shown in Table 1.

**Table 1**

| | | Examples | | | | |
|---|---|---|---|---|---|---|
| | | 1 | 2 | 3 | 4 | 5 |
| Raw material of M range particles | | M-AIN1 | M-AIN1 | M-AIN2 | M-AIN1 | M-AIN1 |
| Proportion of particles with a particle size of 5 to 150 µm | vol % | 91 | 80 | 69 | 71 | 80 |
| L range particles | vol % | 59 | 54 | 47 | 55 | 42 |
| Peak position of above | µm | 120 | 120 | 120 | 120 | 120 |
| M range particles | vol % | 32 | 26 | 22 | 16 | 38 |
| Peak position of above | µm | 19 | 19 | 26 | 19 | 19 |
| S range particles | vol % | 9 | 20 | 31 | 29 | 20 |
| Peak position of above | µm | - | 1 | 1, 0.2 | 1, 0.2 | 1 |
| Mᵢₙₜ/Lᵢₙₜ ratio | | 0.54 | 0.48 | 0.47 | 0.29 | 0.91 |
| Proportion of polyhedral particles in the particle size range of 5 to 50 µm | % | 89 | 79 | 87 | 79 | 83 |
| L/D of the particles in the particle size range of more than 50 µm or more and 150 µm or less | | 1.2 | 1.2 | 1.2 | 1.2 | 1.2 |
| L/D of the particles in the particle size range of 5 to 50 µm | | 1.3 | 1.3 | 1.25 | 1.3 | 1.3 |
| Oxygen content of M range particles | wt% | 0.2 | 0.2 | 0.2 | 0.2 | 0.2 |
| Thermal conductivity of Resin Composition | W/m·K | 6.7 | 9.2 | 9.3 | 9.1 | 8.7 |
| Fluidity of Resin composition | g/min | 65 | 90 | 128 | 102 | 79 |

**Table 1 (continued)**

| | | Comparative Example | | | | | |
|---|---|---|---|---|---|---|---|
| | | 1 | 2 | 3 | 4 | 5 | 6 |
| Raw material of M range particles | | Products commerci ally available | M-AIN1 | M-AIN1 | M-AIN1 | M-AIN1 | M-AIN1 |
| Proportion of particles with a particle size of 5 to 150 µm | vol % | 85 | 91 | 91 | 80 | 80 | 55 |
| L range particles | vol % | 56 | 78 | 44 | 69 | 37 | 38 |
| Peak position of above | µm | 120 | 120 | 120 | 120 | 120 | 120 |
| M range particles | vol % | 29 | 13 | 47 | 11 | 43 | 17 |
| Peak position of above | µm | 17 | 19 | 19 | 19 | 19 | 19 |
| S range particles | vol % | 15 | 9 | 9 | 20 | 20 | 45 |
| Peak position of above | µm | - | - | - | 1 | 1 | 1 |
| Mᵢₙₜ/Lᵢₙₜ ratio | | 0.52 | 0.17 | 1.1 | 0.16 | 1.2 | 0.45 |
| Proportion of polyhedral particles in the particle size range of 5 to 50 µm | % | ≦1 | 89 | 89 | 73 | 81 | 67 |
| L/D of the particles in the particle size range of more than 50 µm or more and 150 µm or less | | 1.2 | 1.2 | 1.2 | 1.2 | 1.2 | 1.2 |
| L/D of the particles in the particle size range of 5 to 50 µm | | 1.3 | 1.3 | 1.3 | 1.3 | 1.3 | 1.3 |
| Oxygen content of M range particles | wt% | 0.2 | 0.2 | 0.2 | 0.2 | 0.2 | 0.2 |
| Thermal conductivity of Resin Composition | W/m·K | 5.8 | 6.4 | 6.1 | 8.0 | 7.7 | 6.4 |
| Fluidity of Resin composition | g/min | 44 | 36 | 59 | 54 | 62 | 6 |

It was found that, by the fact that 50% or more of the particles with a particle size belonging to 5 to 50 µm of the aluminum nitride powder contained in the resin composition of each Example are polyhedral particle, the thermal conductivity of the resin composition when filled into a resin is improved, in addition, by the fact that flat surfaces are present in the particles with a particle size belonging to 5 to 50 µm, the fluidity of the particles is excellent.

### Reference Signs List

- 11, 12: Polyhedral particles
- a: flat surface

## Claims

1. An aluminum nitride powder, comprising:
(i) 60 vol% or more of the proportion of the particles in the range of 5 to 150 µm in all the particles in the volume-based particle size distribution measured by particle size analysis; and
having (ii) peaks in the particle size range of 5 to 50 µm (M range) and the particle size range of more than 50 µm and 150 µm or less (L range) in the frequency distribution curve obtained from the particle size distribution measurement, and having 0.2 to 1.0 of the ratio (Mᵢₙₜ/Lᵢₙₜ) of the proportion (Mᵢₙₜ) of particles in the M range to the proportion (Lᵢₙₜ) of particles in the L range,
wherein, in the scanning electron microscope image taken at 500x magnification, 50% or more of the particles with a particle size belonging to 5 to 50 µm are polyhedral particles having at least two flat surfaces.

2. The aluminum nitride powder according to claim 1, further comprising:
particles with a particle size of less than 5 µm (S range).

3. The aluminum nitride powder according to claim 2,
wherein the particles with a particle size of less than 5 µm (S range) are aluminum nitride particles and/or aluminum oxide particles.

4. A resin composition comprising the aluminum nitride powder according to claim 1, and a resin.

5. A heat dissipation member comprising the resin composition according to claim 4.

6. An electronic apparatus comprising:
the heat dissipation member according to claim 5; and
an electronic device having a heat-generating part or a cooling part,
wherein the heat dissipation member is arranged in the electronic device to be in contact with the heat-generating part.
